# EUROPEAN PATENT APPLICATION

(11) **EP 2 063 513 A1**
(43) Date of publication of application: **27.05.2009**
(21) Application number: 07121261.7
(22) Date of filing: 22.11.2007
(51) Int. Cl.: H02H 3/04, H01R 13/66

(54) **Overload alarm device and method thereof**

(71) Applicant: Yuan An Technology Co.,Ltd., Jhudong Township 310 Hsinchu County (TW)
(72) Inventor: Hsu, Kang-Neng, Hsinchu County 307 (TW)
(74) Representative: Viering, Jentschura & Partner

(57) **Abstract**

An overload alarm device is provided. The device is disposed in an electric auxiliary system for avoiding overload of the system. The device includes a current detection unit, a voltage comparison unit and an alarm unit. The current detection unit includes a non-contact sensor connected to the circuit of the system for sensing the current of the system so as to output a voltage signal corresponding to the current. The voltage comparison unit compares the value of the voltage signal with a preset value. As the value of the voltage signal exceeds the preset value, the voltage comparison unit drives the alarm unit to generate an alarm signal.

## Description

### BACKGROUND OF THE INVENTION

### 1. Field of the Invention

The present invention is related to an alarm device, and more particular to an overload alarm device and method of an electric auxiliary system for avoiding system overload.

### 2. Description of Related Art

The outlets installed in houses and buildings connected to the public electric utility system are transmitting alternating-current into electric auxiliary system connected to them. By plugging into the outlets, electric appliances can obtain alternating-current power. However, the outlets and the attached wires have specific electrical characteristics, such as voltage rating, current rating, and others, which represent the maximum voltage and current the facility can support. Once the current exceeds the rated the line will overload and the wires will over-heat, which accelerates the outlet's and wire's degradation, and can even result in an accidental fire.

Due to the lack of the electric acknowledge and the concept of safety on electric power usage, most people usually connect multiple outlet extension lines or multiplugs to the electric outlets to increase the amount of used electric appliances. Whether the total current of the circuit exceeds the maximum current that the outlet and the wires can support is ignored, which may cause serious danger.

The fuse and the no fuse breaker are two common protection devices used to avoid electric auxiliary circuit overload. These two protection devices are both installed in the distribution circuit inside the power distribution panel. Once the current flows through the protection device exceeds a specific current value, the protection device will open the circuit in order to terminate the transmitted power for ensure the safety of electric power usage.

Although the fuse and the no fuse breaker both can ensure the safety of electric power usage, the user does not know the status of the outlet. Besides, these two protection devices both open the circuit when the current exceeds the rated current value. At this time, the wires of the circuit are already over-heated. The heat will accelerate the degradation of the wire's cover layers and increase the danger of short circuits. Besides, after the circuit is switched off, the user has to replace the fuse or turn on the no fuse breaker in order to make the outlets providing power normally again. This is not convenient. Therefore, the inventor offers the present invention to overcome the problems of the prior art.

### SUMMARY OF THE INVENTION

Accordingly, the scope of the present invention provides an overload alarm device and method for sensing the current in an electric auxiliary system, generating a voltage signal according to the current strength, and giving an alarm signal as the voltage signal exceeds a preset value, thus reminding the user that the current of the circuit has exceeded the limit and that it is necessary to turn off or remove some electric appliances so as to reduce the circuit load.

The present invention provides an overload alarm device disposed in an electric auxiliary system. The overload alarm device includes a current detection unit, a voltage comparison unit, and an alarm unit. The current detection unit includes a non-contact sensor connected to the circuit of the electric auxiliary system for sensing the current of the electric auxiliary system so as to generate a voltage signal. The voltage comparison unit is connected to the current detection unit for comparing the value of the voltage signal with a preset value. The voltage comparison unit generates a driving signal as the value of the voltage signal exceeds the preset value. The alarm unit is connected to the voltage comparison unit for receiving the driving signal and generating an alarm signal in response to the driving signal.

The preset invention further provides an overload alarm method for avoiding an electric auxiliary system overload. The method, according to the present invention, firstly provides a non-contact sensor connected to the circuit of the electric auxiliary system for sensing the current of the electric auxiliary system so as to generate an induced current signal. Next, the induced current signal is converted into a voltage signal. Afterward, the value of the voltage signal is compared to a preset value. If the voltage signal exceeds the preset value, an alarm unit is driven to generate an alarm signal.

The objective of the present invention will become obvious to those of ordinary skill in the art after reading the following detailed description of the preferred embodiment, which is illustrated in the various figures and drawings.

### BRIEF DESCRIPTION OF THE DRAWINGS

- Fig. 1: is a block diagram of the overload alarm device according to the present invention;
- Fig. 2: is an exemplary overload alarm device according to the present invention;

- Fig. 3: is another exemplary overload alarm device according to the present invention;
- Fig. 4: is an exemplary circuit of the overload alarm device according to the present invention; and
- Fig. 5: is a flow chart of the overload alarm method according to the present invention.

### DETAILED DESCRIPTION OF THE PREFERRED EMBODIMENTS

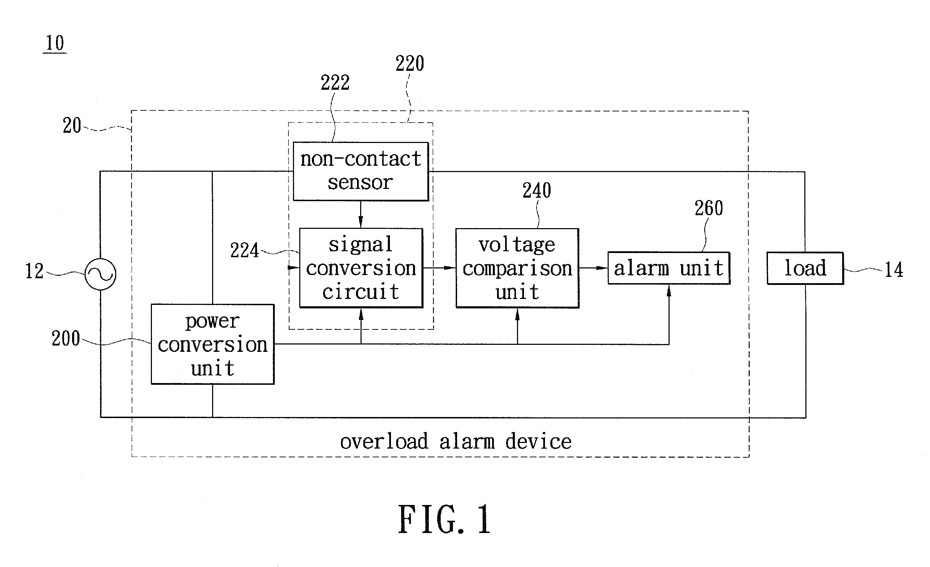

Please refer to Fig. 1 which illustrates a block diagram of the overload alarm device according to the present invention. As shown in Fig. 1, the overload alarm device 20 is disposed in an electric auxiliary system 10 and connected between an alternating-current source 12 and a load 14. The alternating-current source 12 is fed by the public electric utility system. The load 14 depicts the electric appliances obtaining electric power from the same circuit and the electric appliances are connected to the rear end of the overload alarm device 20 via one or multiple extended power lines.

The overload alarm device 20 is used for reminding the user to control the current of electric auxiliary system 10 in order to ensure safety of the electric power usage. It is suggested to set a certain percentage of the current value rated for the outlet, such as 80%∼85%, as the limit value for the current of the electric auxiliary system 10. The overload alarm device 20 checks the current of electric auxiliary system 10 continuously. Once the current value exceeds the current limit value, the overload alarm device 20 generates an alarm sound and/or an alarm light to remind the user to reduce the amount of the switched-on electric appliances in order to reduce the current. The system terminates the alarm once the current is below the current limit value.

The overload alarm device 20 includes a power conversion unit 200, a current detection unit 220, a voltage comparison unit 240, and an alarm unit 260. The current detection unit 220 includes a non-contact sensor 222 and a signal conversion circuit 224. The power conversion unit 200 is connected to the circuit of electric auxiliary system 10 for generating a direct current from the alternating current therein, which is transmitted to the current detection unit 220, the voltage comparison unit 240, and the alarm unit 260 inside the overload alarm device 20.

The non-contact sensor 222 of the current detection unit 220 is a current sensor consisting of a current transformer, a magnetic resistor, or a Hall device. The non-contact sensor 222 generates an induced current signal in response to the current value of electric auxiliary system 10. The signal conversion circuit 224 is connected to the non-contact sensor 222 for converting the induced current signal into a voltage signal. The voltage comparison unit 240 is connected to the current detection unit 220 and compares the value of the voltage signal with a preset value. The voltage comparison unit 240 generates a driving signal as the value of the voltage signal exceeds the preset value. The alarm unit 260 is connected to the voltage comparison unit 240 for receiving the driving signal and generating an alarm signal in response to the driving signal.

The preset voltage value is set in accordance with the limit current value of electric auxiliary system 10 mentioned above, and the way to set this value will be illustrated hereinafter. The alarm unit 260 includes at least one alarm device which can be a sound generating device, such as a buzzer, a speaker, etc., or a lighting device, such as a DC lamp, a light emitting diode, etc., so as to generate an alarm sound or an alarm light.

There are two principal ways to measure current. One way is to dispose a resistor in the circuit and measure the voltage difference between the two ends of the resistor. The other way is to connect a shunt connected to the circuit. However the above ways both will affect the system because of the induced voltage drop and power loss. Therefore, the present invention uses the non-contact sensor 222 to measure the current of electric auxiliary system 10 in place of the former measure way.

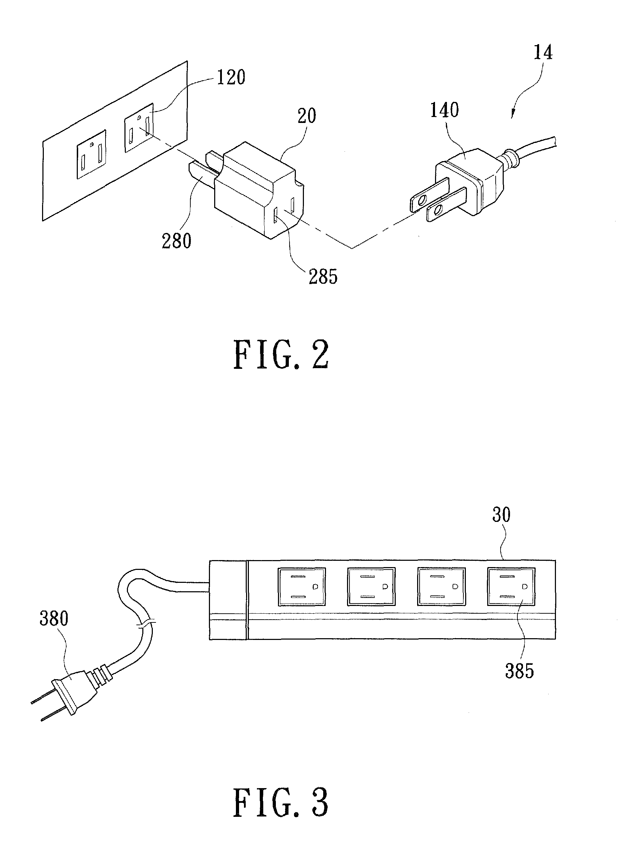

In order to make the concept of the present invention more clear, please refer to Fig. 2 which illustrates an exemplary overload alarm device according to the present invention. The overload alarm device 20 includes a plug 280 and an outlet 285 for connecting an outlet 120 to plug 140 of load 14. The outlet 120 can be inside a wall or can be an extension line. The power conversion unit 200, the current detection unit 220, the voltage comparison unit 240, and the alarm unit 260 are contained inside the overload alarm device 20.

Please refer to Fig. 3 which illustrates another exemplary overload alarm device according to the present invention. As shown in Fig. 3, the overload alarm device 30 is constructed as an electric multiplug and includes a plug 380 and a plurality of outlets 385. One or more sets of the power conversion unit 200, the current detection unit 220, the voltage comparison unit 240, and the alarm unit 260 can be disposed inside the overload alarm device 30 to monitor the current of one single outlet 385 or all the outlets 385.

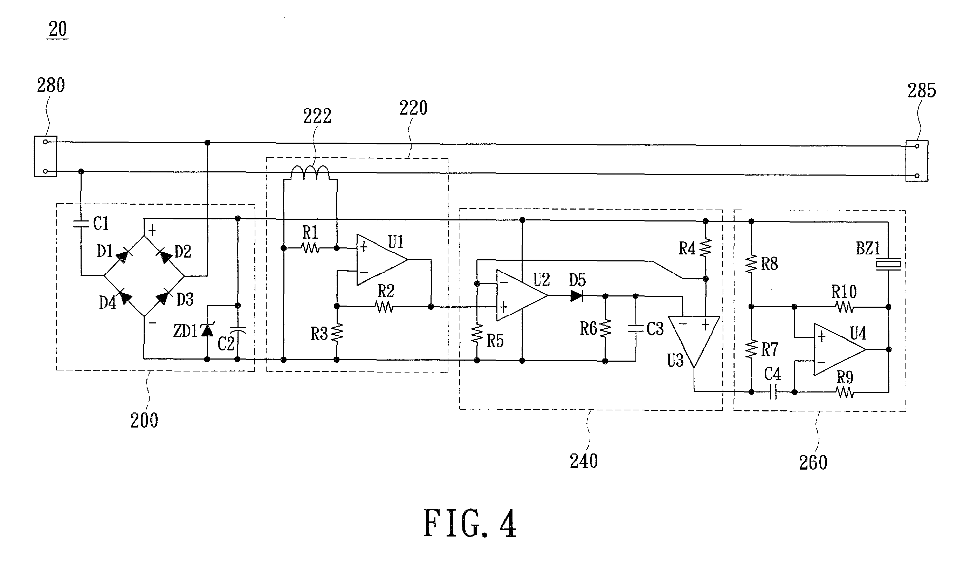

Please refer to both Fig. 1 and Fig. 4. Fig.4 is an exemplary circuit of an overload alarm device for further illustrating in detail the application of the present invention.

The power conversion unit 200 includes a full-bridge rectifier consisting of four diodes D1∼D4 for generating a direct-current supplied to the overload alarm device 20. In the current detection unit 220, the non-contact sensor 222 is coupled to the line or the neutral wire between plug 280 and outlet 285 for sensing the current in the wire and generate an induced current signal. The signal conversion circuit 224 consists of the non-contact sensor 222, an amplifier U1 and three resistors R1∼R3. The amplifier U1 is connected between the non-contact sensor 222 and the voltage comparison unit 240 for sensing the induced current signal outputted from the non-contact sensor 222 and outputting an amplified voltage signal.

The voltage comparison unit 240 includes a primary comparing circuit and a stabilizing/comparing circuit. The primary comparing circuit consists of an amplifier U2 and two resistors R4, R5, and the stabilizing/comparing circuit consists of an amplifier U3, a diode D5, three resistors R4∼R6, and a capacitor C3. In the primary comparing circuit, the amplifier U2 acts as a comparator, and the resistors R4, R5 are connected to the inverting input terminal of amplifier U2 for setting the preset voltage value. The amplifier U2 receives the voltage signal by the non-inverting input terminal and compares the value of the voltage signal with the preset value. If the value of the voltage signal exceeds the preset value, the amplifier U2 outputs a primary controlling signal. The level of the primary controlling signal is stepped up and stabilized by the diode D5, the resistor R6, and the capacitor C3, and further transmitted into the inverting input terminal of amplifier U3. Inside the amplifier U3, the primary controlling signal will be compared to the preset voltage value of the non-inverting input terminal, and finally the amplifier U3 outputs the stabilized driving signal to control the alarm unit 260.

The alarm unit 260 includes a buzzer BZ1 and an oscillating signal generating circuit that consists of an amplifier U4, four resistors R7∼R10, and a capacitor C4, for generating an oscillating signal to drive the buzzer BZ1, thus generating an alarm sound as the voltage comparison unit 240 outputs the driving signal.

It is noted that the circuit shown in Fig.4 is only an exemplary embodiment for illustrating the action of the preset invention. The overload alarm device 20 of the present invention can be implemented by many different circuit structures. For example, except the full-bridge rectifier, the power conversion unit 200 can be implemented by other kinds of AC-DC converting circuits. In another embodiment, a battery can be used to supply the overload alarm device 20 with DC power. Furthermore, the voltage comparison circuit 240 shown in Fig. 4 performs first a voltage comparison of the primary circuit and then performs stabilization by the rear stage circuit. One skilled in the art can apply other circuit structures to stabilize the amplified voltage signal first and then perform the voltage comparison. The alarm unit 260 should be designed in accordance with the applied alarm device. The oscillating signal generating circuit shown in Fig. 4 is for a buzzer without an embedded driving circuit. If the applied buzzer has an embedded driving circuit, it is unnecessary to implement the oscillating signal generating circuit. If a lighting device is selected as the alarm device, a lighting device driving circuit should be constructed inside the alarm unit 260 for driving the lighting device to generate an alarm light. Besides, the major circuit of the overload alarm device 20 can be fabricated on a chip by integrated circuit technology in order to simplify the manufacturing process and reduce the size of the product.

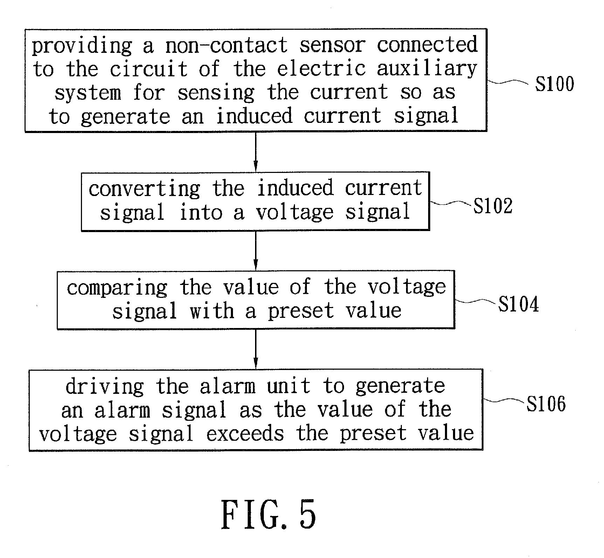

In the following, an overload alarm method of an electric auxiliary system is illustrated. Please refer to Fig. 5 which is a flow chart of the overload alarm method. Please refer to Fig. 1 for elements mentioned hereinafter. As shown in Fig. 5, the method includes the following steps.

Firstly, S 100 is performed. The non-contact sensor 222 is connected to the circuit of the electric auxiliary system 20 for sensing the current thereof and generating an induced current signal.

Next, S102 is performed. The induced current signal is converted into a voltage signal.

Next, S104 is performed. The value of the voltage signal is compared with the preset value.

Last, S106 is performed. When the value of the voltage signal exceeds the preset signal, the alarm unit 260 is driven to generate an alarm signal. Thereby the user will be reminded to keep the current below the limit value.

Afterward, if the current has dropped below the limit value and the value of the voltage signal is lower than the preset value, the alarm unit 260 will terminate the alarm signal.

As illustrated in the above embodiment, the overload alarm device and method thereof determine a percentage of the rated current value of the electric auxiliary system as the limit value and set a preset voltage limit accordingly. Once the line current exceeds the limit value, the overload alarm device will give an alarm immediately, reminding the user to switch off or remove some electric appliances in order to reduce the current to the safe range in which the alarm will be terminated.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. An overload alarm device of an electric auxiliary system, comprising:
a current detection unit, comprising a non-contact sensor connected to the circuit of the electric auxiliary system for sensing the current of the electric
auxiliary system so as to generate a voltage signal in response to the current
value of the current;
a voltage comparison unit, connected to the current detection unit for sensing
the value of the voltage signal, comparing the voltage signal to a preset value and generating a driving signal if the value of the sensing voltage exceeds the preset value; and
an alarm unit, connected to the voltage comparison unit for receiving the driving signal and generating an alarm signal in response to the driving signal.

2. The overload alarm device according to claim 1, wherein the electric auxiliary system comprises an alternating-current source and a load, the alternating-current source is connected to the public electric utility system, and the overload alarm device is connected between the alternating-current source and the load.

3. The overload alarm device according to claim 2, further comprising a plug, an outlet, and at least two wires connected between the plug and the outlet for constructing the overload alarm device between the alternating-current source and the load.

4. The overload alarm device according to claim 3, wherein the non-contact sensor is connected to any one of the two wires.

5. The overload alarm device according to claim 1, wherein the non-contact sensor is one from the group consisting of a current transformer, a magnetic resistor, and a Hall device.

6. The overload alarm device according to claim 1, wherein the alarm unit comprises at least one alarm device for generating the alarm signal.

7. The overload alarm device according to claim 6, wherein the alarm device is a sound generating device or a lighting device.

8. The overload alarm device according to claim 1, further comprising a power conversion unit connected to the circuit of the electric auxiliary system for supplying power the overload alarm device requires from the power transmitted in the electric auxiliary system.

9. The overload alarm device according to claim 1, wherein the non-contact sensor induces a current signal in response to the current of the electric auxiliary system, and the current detection unit comprises a signal conversion circuit for converting the induced current signal into the voltage signal.

10. The overload alarm device according to claim 1, wherein the voltage comparison unit comprises a comparator for comparing the value of the voltage signal and the preset value.

11. An overload alarm method for avoiding overload of an electric auxiliary system, comprising the steps of:
providing a non-contact sensor connected to the circuit of the electric auxiliary system for sensing the current of the electric auxiliary system so as to generate an induced current signal; converting the induced current signal into a voltage signal; comparing the value of the voltage signal with a preset value; and driving an alarm unit to generate an alarm signal as the value of the voltage signal exceeds the preset value.

12. The overload alarm method according to claim 11, wherein the electric auxiliary system comprises an alternating-current source and a load, the alternating-current source is connected to the public electric utility system, and the overload alarm device is connected between the alternating-current source and the load.

13. The overload alarm method according to claim 11, wherein the non-contact sensor is one from the group consisting of a current transformer, a magnetic resistor, and a Hall device.

14. The overload alarm method according to claim 11, wherein the alarm unit comprises at least one alarm device for generating the alarm signal.

15. The overload alarm method according to claim 14, wherein the alarm device is a sound generating device or a lighting device.

16. The overload alarm method according to claim 11, wherein the alarm unit terminates the alarm signal when the value of the voltage signal becomes lower than the preset value.
